# EUROPÄISCHE PATENTSCHRIFT

(11) **EP 1 237 395 B1**
(45) Veröffentlichungstag und Bekanntmachung des Hinweises auf die Patenterteilung: **13.02.2008**
(21) Anmeldenummer: 01130331.0
(22) Anmeldetag: 19.12.2001
(51) Int. Cl.: H05K 1/14

(54) **Leiterplattenanordnung**
Printed circuit board assembly
Assemblage de panneaux à circuit imprimé

(30) Priorität: 28.02.2001 DE 10109571
(43) Veröffentlichungstag der Anmeldung: 04.09.2002
(73) Patentinhaber: Fujitsu Siemens Computers GmbH, 80807 München (DE)
(72) Erfinder: Schmid, Michael, 89407 Dillingen (DE)
(74) Vertreter: Epping - Hermann - Fischer

(56) Entgegenhaltungen:
- US-A- 5 006 961
- US-A- 5 648 891
- US-A- 6 046 912
- US-A- 6 122 161
- US-A- 6 137 678

## Beschreibung

Die Erfindung betrifft eine Leiterplattenanordnung mit einer ersten Leiterplatte mit ersten festgelegten Abmessungen und einer zweiten Leiterplatte, die mittels eines Steckverbinders mit der ersten Leiterplatte verbindbar ist.

Eine Leiterplattenanordnung nach dem Oberbegriff des Anspruchs 1 ist aus US-A-6046912 bekannt.

Derartige Leiterplattenanordnungen sind aus dem Stand der Technik als sogenannte Riser-Karten bekannt. Diese werden zu dem Zweck eingesetzt, zusätzliche Steckplätze bereitzustellen. Eine Riser-Karte wird dabei senkrecht in einen sogenannten PCI-Steckplatz eingesteckt. Die auf die Riser-Card eingesteckten Leiterplatten, sogenannte Erweiterungskarten, liegen dann parallel zur ersten Leiterplatte. Damit befinden sie sich in einem Bereich, in dem die räumlich Anordnung mit anderen auf der Leiterplatte angeordneten Komponenten kollidieren kann. Problematisch ist auch die Anbindung an das Bussystem des Mainboards, da PCT-Steckplätze eigentlich nicht für die Anbindung und Kontrolle mehrerer Erweiterungskarten vorgesehen sind.

Alternativ werden von vorne herein größere Leiterplatten als Mainboard vorgesehen, die mehr Steckplätze für Erweiterungskarten aufweisen. Um sowohl Systeme mit einer geringen Anzahl von Steckplätzen und kleinen Abmessungen als auch Systeme mit einer großen Anzahl von Steckplätzen und verhältnismäßig großen Abmessungen anbieten zu können, werden also zwei verschiedene Mainboardtypen entwickelt, hergestellt und gelagert, was zusätzliche Kosten verursacht.

Aufgabe der Erfindung ist es daher, eine Leiterplattenanordnung anzugeben, die eine einfache Erweiterung der ersten Leiterplatte um weitere Komponenten, insbesondere Steckplätze, ermöglicht.

Diese Aufgabe wird durch eine Anordnung der eingangs genannten Art gelöst, die dadurch gekennzeichnet ist, daß im verbundenen Zustand sich die erste und zweite Leiterplatte in einer Ebene befinden und die Abmessungen der zweiten Leiterplatte so bemessen sind, daß die Anordnung aus der ersten und der zweiten Leiterplatte zweite festgelegte Abmessungen aufweist.

Gemäß der Erfindung wird also eine zweite Leiterplatte über einen Steckverbinder mit der ersten Leiterplatte verbunden, wobei sowohl die Größe der ersten Leiterplatte als auch die Größe der Anordnung aus der ersten und der zweiten Leiterplatte festgelegten Abmessungen entsprechen. Dies ist beispielsweise bei Mainboards für Datenverarbeitungsanlagen der Fall, wo sich verschiedene Standards etabliert haben. Einer der Standards betrifft sogenannte ATX-Boards und der entsprechende zweite Standard dazu wird als µATX bezeichnet. Die Größe der ATX-Boards beträgt 244 mm x 305 mm, während die Größe von µATX-Boards bei 244 mm x 244 mm liegt. Entsprechend gibt es Gehäuse, die für ATX-Boards und andere, die für µATX-Boards geeignet sind. Die Lagerhaltung ist aufwendig, da beide Leiterplatten bevorratet werden müssen. Zudem ist die Entwicklung von zwei verschiedenen Boards sehr aufwendig, obwohl sie gleiche bzw. weitgehend gleiche Funktionalitäten aufweisen.

Besonders vorteilhaft erweist sich die erfindungsgemäße Anordnung, wenn sich sämtliche wichtigen Komponenten auf der ersten Leiterplatte befinden und die zweite Leiterplatte nur noch Steckvorrichtungen zur Aufnahme von Einsteckkarten aufweist. In diesem Fall betreffen die aufwendigen Entwicklungsschritte nur die erste Leiterplatte, so daß dieser Aufwand für verschiedene Größen von Leiterplatten bestehend aus der ersten und zweiten Leiterplatte oder auch nur der ersten Leiterplatte nur einmal geleistet werden muß. Auf der zweiten Leiterplatte sind nur die Steckkarten bzw. eine Verschaltung der Anschlüsse zur Weiterführung auf den Steckanschluß notwendig, wobei dies aus Entwurfsicht verhältnismäßig einfach ist.

Die Erfindung wird nachfolgend anhand eines Ausführungsbeispiels näher erläutert. Es zeigt:
- Figur 1: ein erstes Ausführungsbeispiel einer erfindungsgemäßen Leiterplattenanordnung,
- Figur 2: eine detailliertere Darstellung des Ausführungsbeispiel von Figur 1,
- Figur 3: ein Detail eines PCI-Steckplatzes in einer Draufsicht und
- Figur 4: den PCI-Steckplatz von Figur 3 in einer Seitenansicht.

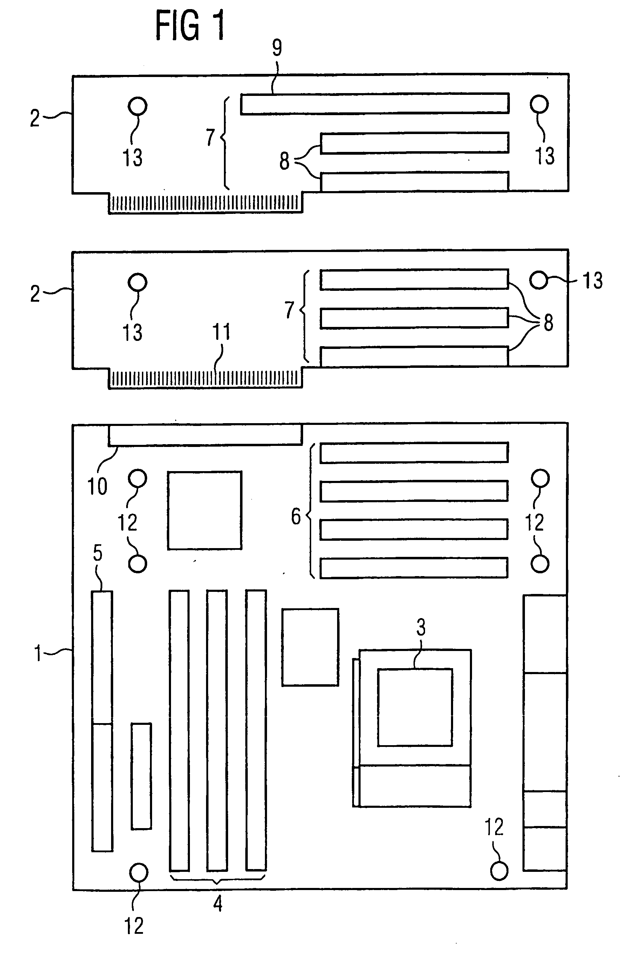

In der Figur 1 ist in einer vereinfachten Darstellung die Anordnung mit zwei Leiterplatten 1 und 2 dargestellt. Alternativ zur zweiten Leiterplatte 2 kann auch eine Leiterplatte 12 vorgesehen werden. Die erste Leiterplatte 1 ist das Mainboard einer Datenverarbeitungseinrichtung und besitzt eine CPU 3, Speicherkomponenten 4, Anschlüsse 5 und Steckplätze 6 für Erweiterungskarten. Die Länge und Breite der Leiterplatte 1 ist festgelegt. Sie ist bestimmt durch Normung oder Quasi-Standards, auf die unter anderem die Gehäusegröße usw. abgestimmt sind. Ebenso abgestimmt sind beispielsweise die Positionierungen der Bohrungen 12 für Befestigungsschrauben. In diesem Fall handelt es sich bei der Leiterplatte 1 um ein Mainboard nach dem µATX-Standard, das eine Größe von 244 mm x 244 mm aufweist .

In vielen Fällen sind aber zusätzliche Steckplätze 7 für Erweiterungskarten gefragt, die auch ein größeres Gehäuse notwendig machen. Bisher wurde in diesem Fall ein anderes Mainboard verwendet, das die erforderlichen zusätzlichen Steckplätze aufweist. Die Größe eines solchen ATX-Boards beträgt 244 mmm x 305 mm. Die Bereitstellung dieser unterschiedlichen Mainboards verursacht erhebliche Kosten in der Entwicklung, Herstellung und Lagerung. Bei Verwendung einer Anordnung nach der Erfindung wird nur noch die erste Leiterplatte 1 nach dem µATX-Standard entwickelt und in den Fällen, in denen weitere Steckplätze 7 notwendig sind, die zweite Leiterplatte 2 als Erweiterungsleiterplatte zu der ersten Leiterplatte 1 durch eine Steckverbindung 10 und 11 mit dieser verbunden. Um für diese erweiterte Leiterplattenanordnung kein besonderes Gehäuse verwenden zu müssen, sieht die Erfindung vor, daß die Abmessungen der zweiten Leiterplatten so ausgelegt sind, daß die Anordnung aus der ersten und zweiten Leiterplatte 1 und 2 zweite festgelegte Abmessungen, nämlich gemäß dem ATX-Standard, aufweist. Bohrungen 13 für Befestigungsschrauben werden idealerweise auf der zweiten Leiterplatte 2 so vorgesehen, daß sie ebenfalls der Position für Bohrungen nach dem ATX-Standard entsprechen. Somit kann ein Standardgehäuse für ATX-Boards und alle entsprechenden Standardkomponenten verwendet werden.

Die Leiterplatte 2 in Figur 1 ist mit drei PCI-Steckplätzen 8 ausgerüstet. Zwischen einem Steckverbinder 11 zum Anschluß an die erste Leiterplatte 1 und den PCI-Steckplätzen 8 sind natürlich Leiterbahnen vorgesehen entsprechend dem vorgeschriebenen Anschluß der Steckplätze 8. Um die Übersichtlichkeit der Figur 1 zu wahren, sind die Leiterverbindungen nicht dargestellt.

Alternativ zu der zweiten Leiterplatte 2 kann eine zweite Leiterplatte 12 eingesetzt werden, die im gezeigten Fall zwei PCI-Steckplätze 8 und einen ISA-Steckplatz 9 besitzt. Eine solche zweite Leiterplatte 12 kann nutzbringend eingesetzt werden, wenn von dem Benutzer der Leiterplattenanordnung ein ISA-Steckplatz 9 gefordert ist, obwohl dies bei modernen Mainboards nicht mehr vorgesehen ist. Ein ISA-Steckplatz 9 ist notwendig, wenn ältere Steckkarten in einer neuen Datenverarbeitungsvorrichtung verwendet werden sollen, der Hersteller aber keine PCI-Version der Steckkarte bereitstellen kann.

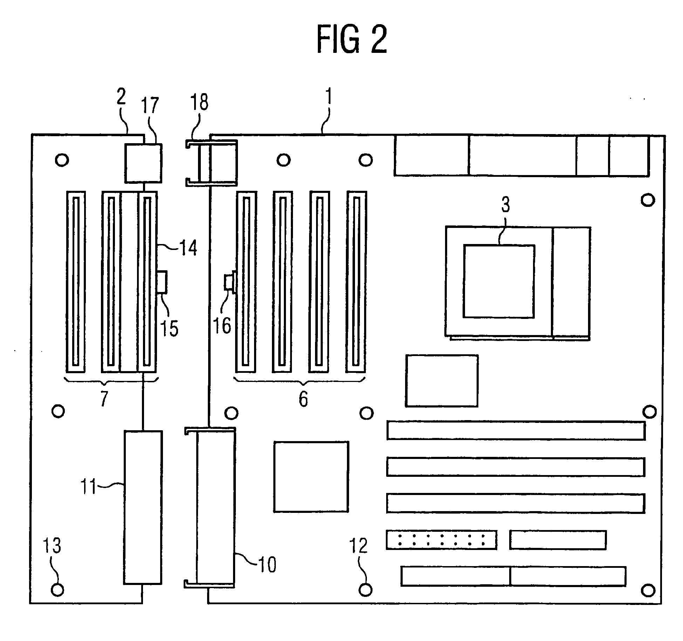

In der Darstellung von Figur 2 ist die Leiterplattenanordnung aus der ersten Leiterplatte 1 und der zweiten Leiterplatte 2 detaillierter dargestellt. Der Steckverbinder 10 auf der ersten Leiterplatte 1 zum Anschluß der zweiten Leiterplatte 2 ist nur dann vorzusehen, wenn eine Erweiterung der ersten Leiterplatte 1 mit der zweiter Leiterplatte 2 gemäß der Erfindung auch tatsächlich vorgesehen ist. Ansonsten sind, im Zuge eines einheitlichen Leiterplattendesigns, lediglich die Anschlüsse für den Steckverbinder 10 vorgesehen. Eine Bestükkung erfolgt aber nicht, so daß an dieser Stelle Kosten eingespart werden können. Die Steckverbinder 10 und 11 sind mechanisch solide ausgeführt, damit auch bei einer mechanischen Belastung durch das Einstecken von Erweiterungskarten in Steckplätze der zweiten Leiterplatte 2 eine zuverlässige elektrische Verbindung sichergestellt werden kann.

Ein gewisses Problem stellt die mechanische Stabilität der zweiten Leiterplatte 2 dar, da die mechanisch einwirkenden Kräfte durch das Einstecken von Erweiterungskarten in die Steckplätze 7 der zweiten Leiterplatte von nur zwei Abstützpunkten bei den Befestigungsschrauben in den Bohrungen 13 aufgefangen werden können. Daher ist in vorteilhafter Weise die Spannungsversorgung der zweiten Leiterplatte 2 durch Steckverbinder 17 und 18 ebenfalls mechanisch solide ausgeführt und außerdem an der anderen Seite des Verbindungsbereichs zwischen der ersten und der zweiten Leiterplatte 1 und 2 angeordnet.

Darüber hinaus ist für die Steckplätze 7 eine Anordnung vorgeschlagen, die es ermöglicht, trotz des Aneinandersetzens der zwei Leiterplatten einen Abstand der Steckplätze 6 bzw. 7 voneinander so zu gewährleisten, wie dies bei einem speziellen ATX-Board der Fall ist. Eine der PCI-Steckerleisten 14 erstreckt sich nämlich über die Kante der zweiten Leiterplatte 2 hinaus, um im zusammengesteckten Zustand auf der Oberfläche der ersten Leiterplatte 1 aufzuliegen. Dadurch findet eine mechanische Übertragung von Kräften, die auf die zweite Leiterplatte 2 wirken, auf die erste Leiterplatte 1 statt. Zudem ist eine Haltenase 15 vorgesehen, durch die in Verbindung mit entsprechenden Rastausnehmungen 16 durch Einrasten sichergestellt ist, daß die beiden Leiterplatten ordnungsgemäß miteinander verbunden und beispielsweise durch Verrutschen nicht wieder getrennt werden können.

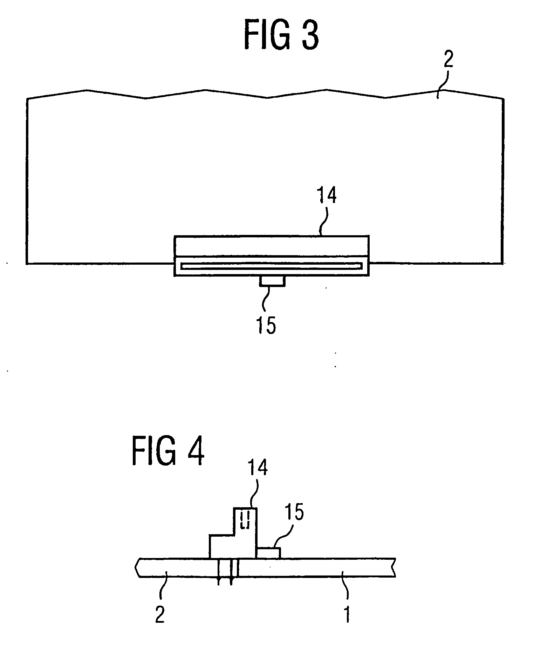

In der Figur 3 ist diese spezielle PCI-Steckerleiste in einer Vergrößerung dargestellt.

Die Figur 4 zeigt die spezielle PCI-Steckerleiste 14 in einem Querschnitt, wobei erkennbar ist, daß die Steckerleiste 14 elektrisch mit der Leiterplatte 2 verbunden ist, mechanisch aber auch eine Verbindung zur ersten Leiterplatte 1 besteht.

Trotz der erfindungsgemäßen Leiterplattenanordnung sind für die Logistik weiterhin zwei unterschiedliche Komponenten vorzusehen. Da die zweiten Leiterplatten 2 jedoch keine empfindlichen elektronischen Komponenten enthalten und darüber hinaus wesentlich kleiner sind als die ersten Leiterplatten 1, ergibt sich auch für die Logistik ein Kostenvorteil.

### Bezugszeichenliste

- 1: erste Leiterplatte
- 2: zweite Leiterplatte
- 3: CPU
- 4: Speicherbausteine
- 5: Steckanschlüsse
- 6: Steckplätze
- 7: Steckplätze
- 8: PCI-Steckplätze
- 9: ISA-Steckplätze
- 10: Steckverbinder
- 11: Steckverbinder
- 12: Bohrungen der ersten Leiterplatte
- 13: Bohrungen der zweiten Leiterplatte
- 14: Spezial-PCI-Steckerleiste
- 15: Rastnase
- 16: Rastausnehmung
- 17: Steckverbinder
- 18: Steckverbinder
- 19: zweite Leiterplatte

## Patentansprüche

1. Leiterplattenanordnung für eine Datenverarbeitungsvorrichtung mit elektronischen Komponenten (3, 4, 5) für eine Funktion als Hauptplatine sowie Steckplätzen (6) für Erweiterungskarten, wobei
- die elektronischen Komponenten (3, 4, 5) für die Funktion als Hauptplatine sowie Steckplätze (6) für Erweiterungskarten auf einer ersten Leiterplatte (1) mit Abmessungen nach einem ersten Standard angeordnet sind,
- weitere Steckplätze (7) für Erweiterungskarten auf einer zweiten Leiterplatte (2) vorgesehen sind,
- die erste Leiterplatte (1) ohne die zweite Leiterplatte (2) betreibbar ist, **dadurch gekennzeichnet, dass**
- die erste und zweite Leiterplatte (1, 2) Steckverbinder (10, 11) aufweisen zum Verbinden der ersten und zweiten Leiterplatte (1, 2), so dass sie sich im verbundenen Zustand in einer Ebene befinden und dabei Abmessungen nach einem zweiten Standard aufweisen.

2. Anordnung nach Anspruch 1,
**dadurch gekennzeichnet, daß**
die ersten und zweiten vorbestimmten Abmessungen durch einen Standard für Datenverarbeitungsanlagen definiert sind.

## Claims

1. Printed circuit board arrangement for a data processing apparatus having electronic components (3, 4, 5) for operation as a main board and also slots (6) for expansion cards, where
- the electronic components (3, 4, 5) for the operation as a main board and slots (6) for expansion cards are arranged on a first printed circuit board (1) having dimensions based on a first standard,
- further slots (7) for expansion cards are provided on a second printed circuit board (2),
- the first printed circuit board (1) can be operated without the second printed circuit board (2),
**characterized in that**
- the first and second printed circuit boards (1, 2) have plug connectors (10, 11) for connecting the first and second printed circuit board (1, 2), so that in the connected state they are situated in one plane and have dimensions based on a second standard.

2. Arrangement according to Claim 1,
**characterized in that**
the first and second predetermined dimensions are defined by a standard for data processing systems.

## Revendications

1. Agencement de cartes de circuit imprimé pour un dispositif de traitement de données, qui présente des composants électroniques (3, 4, 5) pour le fonctionnement comme carte principale ainsi que des emplacements d'enfichage (6) pour des cartes d'extension, dans lequel :
- les composants électroniques (3, 4, 5) qui assurent le fonctionnement comme carte principale ainsi que les emplacements d'enfichage (6) pour les cartes d'extension sont disposés sur une première carte de circuit imprimé (1) dont les dimensions sont conformes à une première norme,
- d'autres emplacements d'enfichage (7) pour des cartes d'extension sont prévus sur une deuxième carte de circuit imprimé (2),
- la première carte de circuit imprimé (1) peut fonctionner sans la deuxième carte de circuit imprimé (2),
**caractérisé en ce que**
- la première et la deuxième carte de circuit imprimé (1, 2) présentent des raccords enfichables (10, 11) qui relient la première et la deuxième carte de circuit imprimé (1, 2) de telle sorte que lorsqu'elles sont assemblées, elles sont situées dans un plan et présentent ainsi des dimensions conformes à une deuxième norme.

2. Agencement selon la revendication 1, **caractérisé en ce que** les premières et les deuxièmes dimensions prédéterminées sont définies par une norme pour des installations de traitement de données.
